# EUROPEAN PATENT APPLICATION

(11) **EP 3 193 380 A1**
(43) Date of publication of application: **19.07.2017**
(21) Application number: 15840583.7
(22) Date of filing: 09.09.2015
(51) Int. Cl.: H01L 35/22, H01L 29/06, H01L 35/14, H01L 35/32, H01L 35/34

(54) **THERMOELECTRIC CONVERSION MATERIAL, PROCESS FOR PRODUCING THERMOELECTRIC CONVERSION MATERIAL, AND THERMOELECTRIC CONVERSION MODULE**

(30) Priority: 10.09.2014 JP 2014183883
(71) Applicant: Honda Motor Company Limited, Tokyo 107-8556 (JP); Furukawa Co., Ltd., Chiyoda-ku Tokyo 100-8370 (JP)
(72) Inventor: HARAGUCHI Tomohide, Wako-shi Saitama 351-0193 (JP); KAWANO Kenta, Wako-shi Saitama 351-0193 (JP); TAKAHASHI Shoji, Wako-shi Saitama 351-0193 (JP); OCHI Takahiro, Tsukuba-shi Ibaraki 305-0856 (JP); KIKUCHI Masaaki, Tsukuba-shi Ibaraki 305-0856 (JP); SUZUKI Shogo, Tsukuba-shi Ibaraki 305-0856 (JP); TOMIDA Taketoshi, Tsukuba-shi Ibaraki 305-0856 (JP); SUMIYOSHI Atsuro, Tsukuba-shi Ibaraki 305-0856 (JP); NIE Ge, Tsukuba-shi Ibaraki 305-0856 (JP); ITO Satoru, Tsukuba-shi Ibaraki 305-0856 (JP); GUO Junqing, Tsukuba-shi Ibaraki 305-0856 (JP)
(74) Representative: Müller, Christian Stefan Gerd
(86) International application number: PCT/JP2015/075584
(87) International publication number: WO 2016/039372

(57) **Abstract**

A thermoelectric conversion material (10) according to an embodiment includes a plurality of parent-phase particles (22) and nanoparticles (30). The parent-phase particles (22) have a crystalline structure. Each of the nanoparticles (30) includes an oxide and exists at an interface between the parent-phase particles (22). The nanoparticles (30) include at least one element that constitutes the crystalline structure. When a range of 6 µm×4 µm of the thermoelectric conversion material (10) is observed with a scanning electron microscope to acquire one sheet of cross-sectional observation image, an average particle diameter d, which is an average of an equivalent circle diameter of a particle group including the parent-phase particles (22) and the nanoparticles (30) which are observed on the cross-sectional observation image, is equal to or more than 100 nm and equal to or less than 1000 nm.

## Description

### TECHNICAL FIELD

The present invention relates to a thermoelectric conversion material, a method of manufacturing the thermoelectric conversion material, and a thermoelectric conversion module.

### BACKGROUND ART

An improvement in thermoelectric conversion performance is demanded with respect to a thermoelectric conversion material. For example, Patent Document 1 discloses a method of improving the thermoelectric conversion performance. In the method, oxide nanoparticles are contained in a thermoelectric conversion material to cause phonon scattering.

### RELATED DOCUMENT

### PATENT DOCUMENT

[Patent Document 1] Japanese Unexamined Patent Publication No. 2013-254924

### SUMMARY OF THE INVENTION

However, in the method described in Patent Document 1, it is necessary to perform a hydrothermal treatment. In addition, from a thorough investigation by the present inventors, it is apparent that the method described in Patent Document 1 cannot cope with a demand for an additional improvement in the thermoelectric conversion efficiency.

The invention is to provide a thermoelectric conversion material excellent in thermoelectric conversion performance.

According to an aspect of the invention, there is provided a thermoelectric conversion material including: a plurality of parent-phase particles having a crystalline structure; and nanoparticles, each including an oxide and existing at an interface between the parent-phase particles. The nanoparticles include at least one element that constitutes the crystalline structure, and when a range of 6 µm×4 µm of the thermoelectric conversion material is observed with a scanning electron microscope to acquire one sheet of cross-sectional observation image, an average particle diameter d, which is an average of an equivalent circle diameter of a particle group including the parent-phase particles and the nanoparticles which are observed on the cross-sectional observation image, is equal to or more than 100 nm and equal to or less than 1000 nm.

According to another aspect of the invention, there is provided a thermoelectric conversion module including the thermoelectric conversion material.

According to still another aspect of the invention, there is provided a method of manufacturing a thermoelectric conversion material. The method includes a step of preparing a plurality of raw materials; a step of producing an alloy powder from the plurality of raw materials; a pulverization step in which the alloy powder is pulverized to form a plurality of parent-phase particles having a crystalline structure, and nanoparticles including an oxide; and a step of sintering a mixture including the parent-phase particles and the nanoparticles. In the pulverization step, the alloy powder is pulverized while repeating pulverization and mutual aggregation, and when a range of 6 µm×4 µm of the thermoelectric conversion material is observed with a scanning electron microscope to acquire one sheet of cross-sectional observation image, an average particle diameter d, which is an average of an equivalent circle diameter of a particle group including the parent-phase particles and the nanoparticles which are observed on the cross-sectional observation image, is equal to or more than 100 nm and equal to or less than 1000 nm.

According to still another aspect of the invention, there is provided a thermoelectric conversion material including: a plurality of parent-phase particles having a crystalline structure; and nanoparticles each of which includes an oxide and is located at an interface between the parent-phase particles. The nanoparticles include at least one element that constitutes the crystalline structure, and an oxygen content based on the entirety of the thermoelectric conversion material is equal to or less than 10 mass%.

According to the aspects of the invention, it is possible to provide a thermoelectric conversion material excellent in thermoelectric conversion performance.

### BRIEF DESCRIPTION OF THE DRAWINGS

The above and other objects, features and advantages will be more apparent from the following description of preferred embodiments taken in conjunction with the accompanying drawings.

FIG. 1 is a view schematically illustrating an example of a structure of a thermoelectric conversion material according to an embodiment.
FIG. 2 is a view illustrating a measurement method of an average particle diameter d according to the embodiment.
FIG. 3 is a view schematically illustrating an example of a structure of a thermoelectric conversion module according to the embodiment.
FIG. 4 is a view schematically illustrating an example of a structure of a gas atomization apparatus.
FIG. 5 is a view schematically illustrating an example of a structure of a dry bead mill apparatus.
FIG. 6 is a view illustrating an example of a pulverization step according to the embodiment.

### DESCRIPTION OF EMBODIMENTS

Hereinafter, an embodiment of the invention will be described with reference to the accompanying drawings. Furthermore, the same reference numeral will be given to the same constituent element, and description thereof will not be repeated.

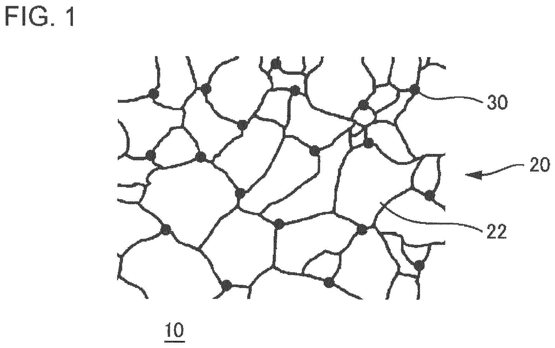

FIG. 1 is a view schematically illustrating an example of a structure of a thermoelectric conversion material 10 according to the embodiment.

The thermoelectric conversion material 10 according to this embodiment includes a plurality of parent-phase particles 22 and nanoparticles 30. The parent-phase particles 22 have a crystalline structure. Each of the nanoparticles 30 includes an oxide, and exists at an interface between the parent-phase particles 22. The nanoparticles 30 include at least one element that constitutes the crystalline structure. When a range of 6 µm×4 µm of the thermoelectric conversion material 10 is observed with a scanning electron microscope to acquire one sheet of cross-sectional observation image, it is preferable that an average particle diameter d, which is an average of an equivalent circle diameter of a particle group including the parent-phase particles 22 and the nanoparticles 30 which are observed on the cross-sectional observation image, is equal to or more than 100 nm and equal to or less than 1000 nm. Hereinafter, description will be made in detail.

The thermoelectric conversion material 10 has a structure in which the parent-phase particles 22 and the nanoparticles 30 are densely aggregated. Each of the parent-phase particles 22 is a crystalline particle, and an interface is present between the parent-phase particles 22. The nanoparticles 30 mainly have a composition of oxides obtained through oxidation of the parent-phase particles 22 or oxides of elements included in the crystalline structure of the parent-phase particles 22, and are scattered in the interface between the parent-phase particles 22. In addition, a void may be present in the thermoelectric conversion material 10, and the nanoparticles 30 may be aggregated in the void. For example, the thermoelectric conversion material 10 may be a composite material in which the nanoparticles 30 are dispersed in a matrix 20.

The nanoparticles 30 are oxide that occurs on the basis of the parent-phase particles 22, and an oxygen content ratio in the nanoparticles 30 is higher in comparison to the parent-phase particles 22. Furthermore, distribution of the oxygen content ratio (for example, a constituent element ratio (atomic%)) in the thermoelectric conversion material 10 may be measured by using energy dispersible X-ray spectrometry (EDX). The shape of the nanoparticles 30 is not particularly limited. Each of the nanoparticles 30 may exist at an interface between the parent-phase particles 22, for example, in a sphere shape or a layer shape. It is preferable that the thermoelectric conversion material 10 includes a plurality of spherical nanoparticles 30. In addition, from the viewpoint of improving thermoelectric conversion efficiency, it is preferable that the thermoelectric conversion material 10 includes the plurality of spherical nanoparticles 30 having a particle diameter of 100 nm or less, and more preferably 50 nm or less. Here, the spherical shape is not limited to a perfect sphere, and a cross-section that is observed by a scanning electron microscope may be an oval or a polygon. In addition, the particle diameter represents an equivalent circle diameter of a cross-section that is observed with the scanning electron microscope.

When a range of 6 µm×4 µm of the thermoelectric conversion material 10 is observed with the scanning electron microscope to acquire one sheet of cross-sectional observation image, it is preferable that an average particle diameter d, which is an average of an equivalent circle diameter of a particle group including the parent-phase particles 22 and the nanoparticles 30 which are observed on the cross-sectional observation image, is equal to or more than 100 nm and equal to or less than 1000 nm. In addition, it is more preferable that the average particle diameter d is equal to or more than 200 nm, and still more preferably equal to or more than 300 nm. In addition, it is more preferable that the average particle diameter d is equal to or less than 800 nm, and still more preferably equal to or less than 750 nm. In a case where the average particle diameter d is equal to or more than the lower limit and is equal to or less than the upper limit, it is possible to further improve conversion performance of the thermoelectric conversion material 10.

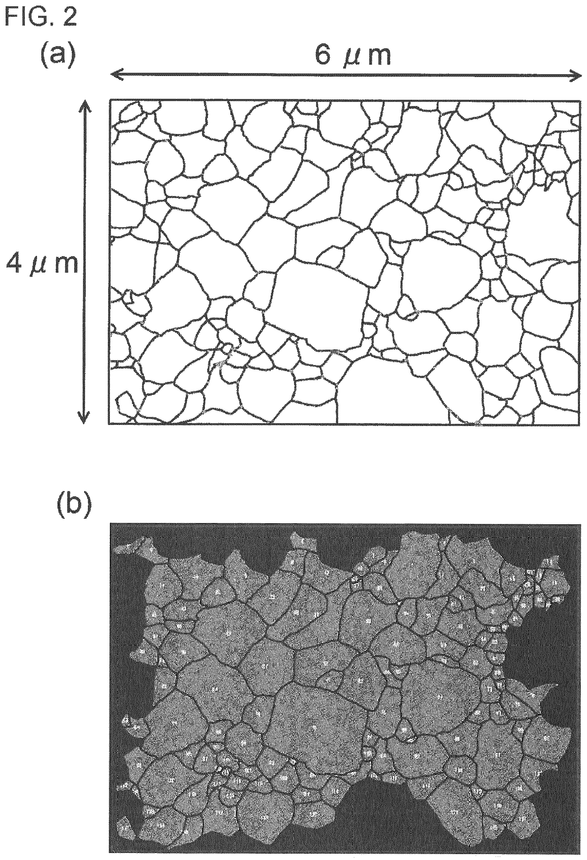

FIG. 2 is a view illustrating a measurement method of the average particle diameter d. The average particle diameter d can be measured as follows. First, a small piece is cut out from the thermoelectric conversion material 10, and is processed and polished into a sample having a flat surface (an exposed surface of a cross-section). The flat surface of the sample is observed with the scanning electron microscope (SEM). An observation image that is obtained is subjected to image analysis to calculate an equivalent circle diameter of respective particles in the observation image. An average value of the equivalent circle diameter of the particles in the observation image is obtained as the average particle diameter d. A more specific method is as follows. In observation of the cross-section, a range of 6 µm×4 µm is acquired as one sheet of observation image. In the image analysis, first, an interface between particles in the observation image is extracted as illustrated in FIG. 2(a). In addition, in a case where the extracted interface is closed in the observation image, an inner side of the closed interface is regarded as a cross-section of one particle, and the inner side is extracted as illustrated in FIG. 2(b). A cross-sectional area and an equivalent circle diameter of cross-sections of a plurality of particles which are extracted from the observation image are respectively obtained. Here, an area of a circle in which the equivalent circle diameter is set as a diameter, and the cross-sectional area are the same as each other. The average particle diameter is set to an average value of 20 or more equivalent circle diameters. In a case where 20 equivalent circle diameters are not obtained in one sheet of observation image, calculation is performed by using two or more sheets of observation images.

The parent-phase particles 22 and the nanoparticles 30 may be included in the particles extracted in FIG. 2(b). However, fine particles, a thin layer, and the like, which are not clearly observed from the observation image in the above-described range, do not have an effect on the average particle diameter d. The nanoparticles 30 are mainly minuter than the parent-phase particles 22 , and the average particle diameter d becomes a value that is close to the average particle diameter of the parent-phase particles 22.

It is preferable that the oxygen content based on the entirety of the thermoelectric conversion material 10 is equal to or less than 10 mass%, more preferably equal to or less than 0.80 mass%, and still more preferably equal to or less than 0.50 mass%. When the oxygen content is equal to or less than the upper limit, it is possible to further improve the conversion performance of the thermoelectric conversion material 10. In addition, it is preferable that the oxygen content based on the entirety of the thermoelectric conversion material 10 is equal to or more than 0.01 mass%, and more preferably equal to or more than 0.15 mass%. When the oxygen content is equal to or more than the lower limit, it is possible to further improve the conversion performance of the thermoelectric conversion material 10.

Furthermore, a more preferable range of the oxygen content may be different in correspondence with an element contained in the thermoelectric conversion material 10 or a composition of the thermoelectric conversion material 10, and thus the more preferable range may also be selected in correspondence with the contained element or the composition.

The oxygen content in the thermoelectric conversion material 10 can be measured by using an inert gas fusion method.

It is preferable that a carrier concentration of the majority carrier in the thermoelectric conversion material 10 is equal to or more than 1.0×10²³ m⁻³, more preferably equal to or more than 1.0×10²⁵ m⁻³, and still more preferably equal to or more than 4.0×10²⁶ m⁻³. In addition, it is preferable that the carrier concentration of the majority carrier in the thermoelectric conversion material 10 is equal to or less than 1.0×10²⁹ m⁻³, more preferably equal to or less than 1.0×10²⁷ m⁻³, and still more preferably equal to or less than 9.0×10²⁶ m⁻³. When the carrier concentration is equal to or more than the lower limit and equal to or less than the upper limit, it is possible to further improve the conversion performance of the thermoelectric conversion material 10. The carrier concentration may also be selected in accordance with an element contained in the thermoelectric conversion material 10 or a composition of the thermoelectric conversion material 10.

A carrier concentration of a hole and a carrier concentration of an electron in the thermoelectric conversion material 10 can be measured by using a hall effect measurement device. A carrier concentration of the majority carrier is relatively greater, and represents a carrier concentration of a hole in a p-type thermoelectric conversion material 10, and a carrier concentration of an electron in an n-type thermoelectric conversion material 10.

In the thermoelectric conversion material 10, it is preferable that the maximum value of a dimensionless figure of merit ZT is equal to or more than 1. When the maximum value of the ZT is equal to or more than 1, the thermoelectric conversion material 10 is suitable for practical use.

In addition, in the thermoelectric conversion material 10, it is preferable that a ZT integrated value obtained by integrating the ZT in a temperature range of 100°C to 600°C is equal to or higher than 170K, more preferably, equal to or higher than 350K, and still more preferably equal to or higher than 370K.

Examples of an index indicating the performance of the thermoelectric conversion material include the dimensionless figure of merit ZT to be described later in detail. The ZT is a value that depends on a temperature T. Even when the ZT is excellent at a certain temperature, if the ZT is poor at another temperature zone at which a use is assumed, it is difficult to realize excellent thermoelectric conversion in practical use. The present inventors focused on the ZT integrated value at a temperature zone, at which a use is assumed, as an index indicating the conversion performance, and found that it is possible to more effectively improve the thermoelectric conversion performance in practical use by raising the ZT integrated value.

The ZT integrated value can be obtained as follows. First, a Seebeck coefficient S, electrical resistivity p, and thermal conductivity κ are measured in a temperature range of 100°C to 600°C, and the dimensionless figure of merit ZT is calculated from a relationship of ZT=S²T/(κ·ρ). Here, S represents a Seebeck coefficient, T represents an absolute temperature, κ represents thermal conductivity, and ρ represents electrical resistivity. In addition, the ZT is obtained as a ZT integrated value through integration in a temperature range of 100°C to 600°C, that is, at T of 373 to 873K.

The thermoelectric conversion material 10 according to this embodiment includes the parent-phase particles 22 having a crystalline structure, and it is preferable that the crystalline structure has a composition that is mainly expressed by a general formula RᵣTₜXₓ (0≤r≤1, 3≤t≤5, 9≤x≤15). Here, R includes one or more kinds of elements selected from the group consisting of rare-earth elements, alkali metal elements, alkaline-earth metal elements, group 4 elements, and group 13 elements. T includes one or more kinds of elements selected from the group consisting of transition metal elements excluding rare-earth elements and group 4 elements. X includes one or more kinds of non-metallic elements selected from the group consisting of group 14 elements, group 15 elements excluding nitrogen, and group 16 elements excluding oxygen.

Examples of the rare-earth elements include Sc, Y, La, Ce, Pr, Nd, Sm, Eu, Gd, Tb, Dy, Ho, Er, Tm, Yb, and Lu. Examples of the alkali metal elements include Li, Na, K, Rb, Cs, and Fr. Examples of the alkaline-earth metal element include Ca, Sr, and Ba. Examples of the group 4 elements include Ti, Zr, and Hf. Examples of the group 13 elements include B, Al, Ga, In, and Tl.

In a case where R includes a plurality of elements, the plurality of elements may be a plurality of elements selected from two or more groups different from each other, or a plurality of elements selected from the same group. It is more preferable that R includes five or more elements selected from three or more groups different from each other from the viewpoint of improving the thermoelectric conversion performance.

In a p-type thermoelectric conversion material, for example, R may mainly include one or more kinds of elements selected from the group consisting of La and Ce which are rare-earth elements, Ti, Zr, and Hf which are group 4 elements, and Al, Ga, and In which are group 13 elements. In an n-type thermoelectric conversion material, for example, R may mainly include one or more kinds of elements selected from the group consisting of Yb that is a rare-earth element, Ca, Sr, and Ba which are alkaline-earth metal elements, Al, Ga, and In which are group 13 elements.

The thermoelectric conversion material 10 may be the n-type or the p-type. Furthermore, when the thermoelectric conversion material 10 is the n-type, it is possible to more effectively improve the thermoelectric conversion performance.

Examples of the transition metal elements excluding rare-earth elements and group 4 elements include V, Nb, Ta, Cr, Mo, W, Mn, Tc, Re, Fe, Ru, Os, Co, Rh, Ir, Ni, Pd, Pt, Cu, Ag, and Au. From the viewpoint of improving the thermoelectric conversion performance of the thermoelectric conversion material 10, it is preferable that T mainly includes one or more kinds of elements selected from the group consisting of Fe, Co, and Ni, and more preferably T consists of Fe and Co.

Examples of the group 14 elements include C, Si, and Ge. Examples of the group 15 elements include P, As, and Sb. Examples of the group 16 elements include S, Se, and Te. It is preferable that R includes Sb from the viewpoint of improving the thermoelectric conversion performance, and more preferably R consists of Sb.

There is no particular limitation to a composition of the thermoelectric conversion material 10 according to this embodiment as long the composition is expressed by the general formula RᵣTₜXₓ (0≤r≤1, 3≤t≤5, 9≤x≤15). However, it is preferable that the thermoelectric conversion material 10 has a skutterudite structure, and it is more preferable that X is set to pnictogen element (group 15 element), and the thermoelectric conversion material 10 has a filled skutterudite structure expressed by a chemical formula RT₄X₁₂.

Furthermore, a structure, in which parts of constituent elements in the crystalline structure having the above-described composition are substituted with one or more elements among oxygen, nitrogen, and other impurities which are unintentionally mixed-in, may be slightly included in the crystalline structure of the parent-phase particles 22.

Furthermore, one or more elements among oxygen, nitrogen, and other impurity elements which are unintentionally mixed-in may be slightly included in the parent-phase particles 22 as an atom.

Hereinafter, description will be given of a thermoelectric conversion module 40 according to this embodiment.

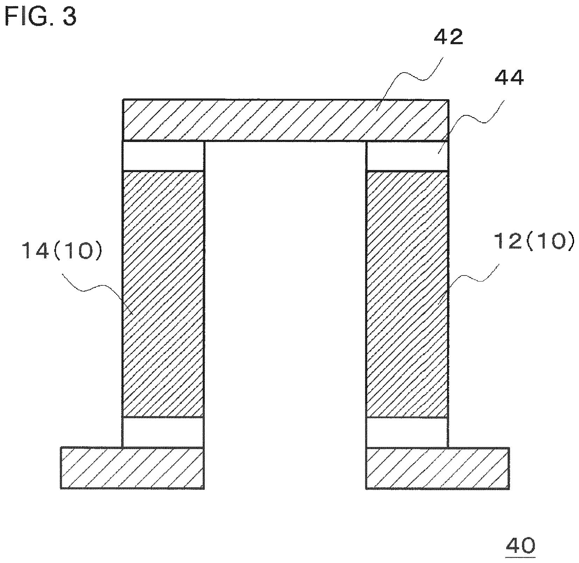

FIG. 3 is a view schematically illustrating an example of a structure of the thermoelectric conversion module 40 according to this embodiment.

The thermoelectric conversion module 40 includes the above-described thermoelectric conversion material 10. Hereinafter, description will be made in detail.

The thermoelectric conversion module 40 according to this embodiment includes at least an n-type thermoelectric conversion material 12 and a p-type thermoelectric conversion material 14 one by one as the thermoelectric conversion material 10. In addition, the thermoelectric conversion module 40 further includes a plurality of electrodes 42 and a bonding member 44. In the thermoelectric conversion module 40, one or more pairs of the n-type thermoelectric conversion material 12 and the p-type thermoelectric conversion material 14 are electrically connected in series. It is possible to directly convert thermal energy into electrical energy by using the thermoelectric conversion module 40. Alternatively, it is possible to directly convert the electrical energy into the thermal energy.

The bonding member 44 functions as a bonding member that bonds each of the n-type thermoelectric conversion material 12 and the p-type thermoelectric conversion material 14, and the electrodes 42. The bonding member 44 is a bonding layer that includes at least one kind of metal layers selected from the group consisting of copper, a copper alloy, aluminum, an aluminum alloy, titanium, a titanium alloy, nickel, a nickel alloy, cobalt, a cobalt alloy, iron, and an iron alloy. In addition, the bonding member 44 may be constituted by one kind of metal layer, or may be constituted by two or more kinds of metal layers. The bonding member 44 may be laminated on the thermoelectric conversion material 10 by a known method such as sputtering, deposition, thermal spraying, and a spark plasma sintering (SPS) method.

The electrode 42 is connected to the n-type thermoelectric conversion material 12 and the p-type thermoelectric conversion material 14 through the bonding members 44. It is preferable that the electrode 42 includes at least one kind of metal layers selected from the group consisting of copper, a copper alloy, aluminum, an aluminum alloy, titanium, a titanium alloy, nickel, a nickel alloy, cobalt, a cobalt alloy, iron, and an iron alloy. In addition, it is more preferable that a layer, which is in contact with the bonding member 44, in the electrode 42 and a layer, which is in contact with the electrode 42, in the bonding member 44 are constituted by a metal having the same composition. According to this, it is possible to enhance adhesiveness on both sides. For example, the electrode 42 may include at least one kind of metal layers selected from the group consisting of chromium, copper, palladium, tin, and niobium. The electrode 42 may be laminated on the bonding member 44 by a known method such as sputtering, deposition, thermal spraying, an SPS method, and fine laser welding.

Next, description will be given of a method of manufacturing the thermoelectric conversion material 10 according to this embodiment.

The method of manufacturing the thermoelectric conversion material 10 includes a step of preparing a plurality of raw materials, a step of producing an alloy powder 50, a pulverization step, and a sintering step. In the step of producing the alloy powder 50, the alloy powder 50 is produced by using a plurality of raw materials which are prepared. In the pulverization step, the alloy powder 50 is pulverized to form a plurality of the parent-phase particles 22 having a crystalline structure, and the nanoparticles 30 including an oxide. In the sintering step, a mixture including the parent-phase particles 22 and the nanoparticles 30 is sintered. In the pulverization step, the alloy powder 50 is pulverized while repeating pulverization and mutual aggregation. As described above, when a range of 6 µm×4 µm of the thermoelectric conversion material 10 is observed with the scanning electron microscope to acquire the one sheet of cross-sectional observation image, the average particle diameter d, which is an average of an equivalent circle diameter of a particle group including the parent-phase particles 22 and the nanoparticles 30 which are observed on the cross-sectional observation image, is preferably equal to or more than 100 nm and equal to or less than 1000 nm. Hereinafter, description will be made in detail.

First, in the step of preparing a raw material, a plurality of the raw materials are prepared. The raw materials are raw materials composed of elementary substances of the elements included in the general formula of the parent-phase particles 22, and raw materials of pure metals.

The step of producing the alloy powder 50 according to this embodiment can be performed by using atomization methods. Among these, it is preferable to use a gas atomization method. When using the gas atomization method, it is possible to stably manufacture the thermoelectric conversion material 10 with high performance.

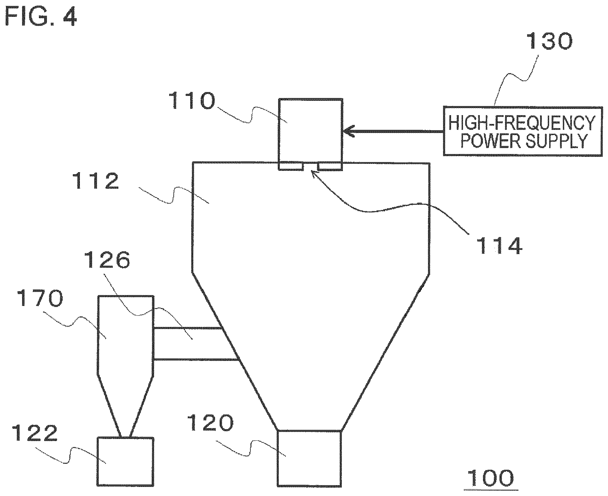

Hereinafter, description will be given of a gas atomization apparatus 100 that is used in the step of producing the alloy powder 50 according to this embodiment. FIG. 4 is a view schematically illustrating an example of a structure of the gas atomization apparatus 100.

As illustrated in the drawing, the gas atomization apparatus 100 includes a crucible 110, a spraying chamber 112 that is provided below the crucible 110, a collection chamber 120 that is provided below the spraying chamber 112, and a collection chamber 122 that collects the alloy powder 50 that is generated in the spraying chamber 112 through a powder separator 170 (cyclone separator) that is connected to the spraying chamber 112.

The crucible 110 is connected to a high-frequency power supply 130. The crucible 110 is subjected to high-frequency heating by the high-frequency power supply 130. According to this, the raw materials in the crucible 110 are heated.

A nozzle 114, which connects the crucible 110 and the spraying chamber 112, is provided therebetween. The raw materials which are melted and are retained in the crucible 110 are added dropwise from the nozzle 114 to the spraying chamber 112. In addition, a spraying gas is sprayed to the raw materials, which are added dropwise, to obtain fine particles. The raw materials, which are sprayed into the spraying chamber 112, are cooled and solidified in the course of descending in the spraying chamber 112. According to this, the alloy powder 50 is produced.

The collection chamber 122 is located on a lower side of the powder separator 170 that is connected to the spraying chamber 112 through a conveyance pipe 126 that is provided on a lateral surface of the spraying chamber 112. As to be described later, a part of the alloy powder 50 that is produced in the spraying chamber 112 is suctioned by the powder separator 170 that is connected to the spraying chamber 112, is transmitted to the powder separator 170 through the conveyance pipe 126, and is collected to a collection chamber 122 side.

Hereinafter, description will be given of an example of a method of producing the alloy powder 50 according to this embodiment.

First, the plurality of raw materials explained above are put into the crucible 110 in a predetermined ratio. Next, the crucible 110 is heated up to 1200°C through high-frequency heating by using the high-frequency power supply 130, and retention is performed for one hour. According to this, the raw materials, which are retained in the crucible 110, are heated and melted.

At this time, the crucible 110 is covered with a lid. According to this, when the raw materials are heated and melted, it is possible to prevent a harmful material such as Sb, which is included in the raw materials, from being discharged to the outside.

Next, a temperature inside the crucible 110 is raised through high-frequency heating to raise a temperature of the raw materials. When the temperature of the raw materials is raised, it is possible to enhance flowability of the raw materials. For example, the temperature raising of the raw materials is performed in a short period of five minute or shorter. According to this, it is possible to suppress evaporation of the raw materials.

For example, the temperature of the raw materials, which are retained in the crucible 110, is raised from 1200°C that is a retention temperature to 1250°C. It is preferable that a temperature rising width of the raw materials which are retained in the crucible 110 is equal to or higher than 10°C and equal to or lower than 100°C. When the temperature rising width is set to 10°C or higher, it is possible to obtain sufficient flowability for spraying the raw materials into the spraying chamber 112 by using the gas atomization method. In addition, when the temperature rising width is set to 100°C or lower, it is possible to suppress evaporation of the raw material, and it is possible to suppress a composition of the raw materials from varying.

As described above, promptly after raising the temperature of the raw materials, the raw materials, which are melted and retained in the crucible 110, are sprayed to the spraying chamber 112 by using the gas atomization method, thereby producing the alloy powder 50. The raw materials, which are retained in the crucible 110, are added dropwise from the nozzle 114 to the spraying chamber 112.

For example, the production of the alloy powder 50 by the gas atomization method is performed as follows. Specifically, the spraying gas is sprayed to the raw materials, which are added dropwise from the inside of the crucible 110 to the spraying chamber 112, to obtain fine particles. As the spraying gas, for example, an argon gas can be used. A spraying pressure of the spraying gas is, for example, 6 MPa. In addition, the raw materials, which are sprayed into the spraying chamber 112, are cooled and solidified in the course of descending in the spraying chamber 112. According to this, the alloy powder 50 is produced.

Next, a plurality of the alloy powders 50 which are produced in the spraying chamber 112 are classified. Classification of the alloy powders 50 is performed by the collection chamber 120 and the collection chamber 122.

Among the alloy powders 50 which are produced in the spraying chamber 112, powders having a large particle diameter descend without being suctioned by the powder separator 170 that is connected to the spraying chamber 112, and are collected by the collection chamber 120. A median diameter of the alloy powder 50 which are collected in the collection chamber 120 is, for example, equal to or more than 40 µm and equal to or less than 100 µm.

On the other hand, the other alloy powders 50 are suctioned by the powder separator 170 that is connected to the spraying chamber 112, are transmitted to the powder separator 170 through the conveyance pipe 126, and are collected by the collection chamber 122. The median diameter of the alloy powders 50 which are collected by the collection chamber 122 is, for example, equal to or more than 10 µm and equal to or less than 20 µm.

In the step of producing the alloy powder 50, for example, a melt spinning method may be used instead of the gas atomization method. For example, the melt spinning method is a single-roll melt spinning method or a twin-roll melt spinning method. In a case of using the melt spinning method, the alloy powder 50 can be mainly obtained as flake-shaped particles.

Hereinafter, description will be given of a method of producing the alloy powder 50 by using the single-roll melt spinning method as a modification example of the step of producing the alloy powder 50.

In the single-roll melt spinning method, a raw material that is prepared is heated and melted, and is sprayed to a single roll that rotates. During spraying, the single roll is in a cooled state, and the raw material that is melted is rapidly cooled on the single roll to obtain a ribbon-shaped thin piece. The thin piece is roughly pulverized to obtain a flake-shaped alloy powder 50. Spraying of the raw material that is melted with respect to the single roll, or pulverization of the thin piece is performed in an inert gas atmosphere, and the alloy powder 50 is collected without being exposed to the air.

In the single-roll melt spinning method, for example, heating and melting of the raw material can be performed by subjecting the raw material to high-frequency heating up to a temperature equal to or higher than 1000°C and equal to or lower than 1300°C in vacuo or in an inert gas atmosphere, and by retaining the raw material for 30 seconds to 10 minutes. For example, as the single roll, a Cu roll having a diameter of 300 mm can be used. For example, the raw material that is melted is sprayed while rotating the single roll at a rotation speed that is equal to or faster than 1000 rpm and equal to or slower than 5000 rpm. For example, a spraying nozzle having a diameter of 0.5 mm can be used during spraying of the raw material.

In the step of producing the alloy powder 50, for example, a water atomization method, a centrifugal atomization method, a mechanical alloying method, a melting method, a solid phase reaction method, a chemical synthesis method, a single crystal growth method, and the like can be used instead of the gas atomization method, the single-roll melt spinning method, and the twin-roll melt spinning method. Examples of the melting method include a heating melting method, a high-frequency melting method, and an arc melting method. A shape of the alloy powder 50 is not particularly limited, and may be different depending on a production method thereof.

The alloy powder 50 is a particle that includes an alloy, which is composed of elements included in respective raw materials which are prepared, as a main component. For example, the alloy powder 50 has a composition expressed by a general formula RᵣTₜXₓ (0≤r≤1, 3≤t≤5, 9≤x≤15). In addition, a particle surface of the alloy powder 50 may be slightly oxidized.

Next, the pulverization step is performed. For example, the pulverization step according to this embodiment may be performed by a dry bead mill method.

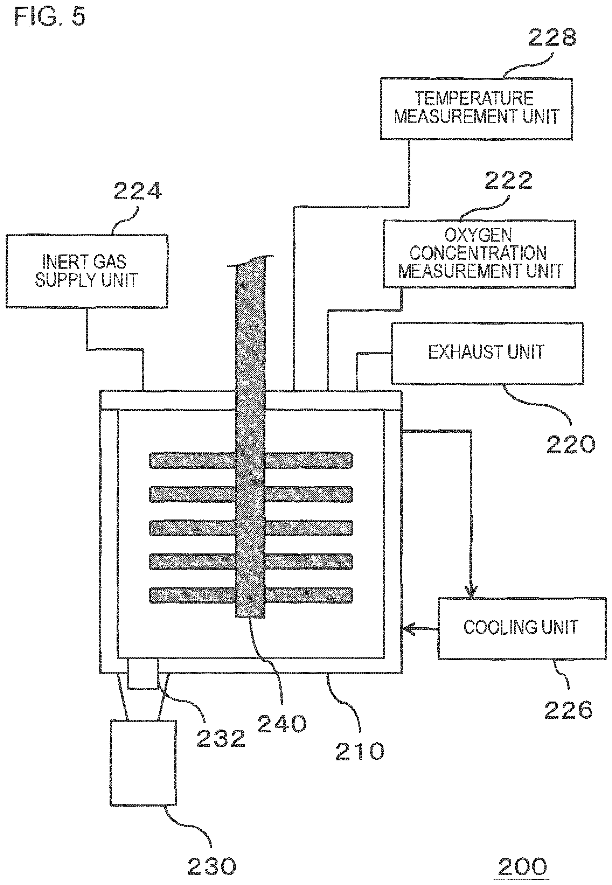

Hereinafter, description will be given of an example of a structure of a dry bead mill apparatus 200 that is used in the dry bead mill method with reference to FIG. 5. The dry bead mill apparatus 200 includes a pulverization container 210, an exhaust unit 220, an oxygen concentration measurement unit 222, an inert gas supply unit 224, a cooling unit 226, a temperature measurement unit 228, a collection container 230, a discharging valve 232, and an agitator 240. The agitator 240, that stirs the inside of the pulverization container 210, is inserted into the pulverization container 210. The exhaust unit 220 evacuates the inside of the pulverization container 210. The oxygen concentration measurement unit 222 measures an oxygen concentration inside the pulverization container 210. The inert gas supply unit 224 supplies an inert gas into the pulverization container 210. For example, an argon gas or a nitrogen gas can be used as the inert gas. The pulverization container 210 has a double structure, and the cooling unit 226 circulates cooling water in a space between an inner wall and an outer wall of the pulverization container 210 to prevent excessive temperature rising in the pulverization container 210. The temperature measurement unit 228 measures a temperature on an inner side of the pulverization container 210. The collection container 230 is connected to a lower side of the pulverization container 210 through the discharging valve 232.

Next, description will be given of a pulverization method of the alloy powder 50 by using the dry bead mill apparatus 200.

Specifically, the pulverization method can be performed as follows. First, the alloy powder 50 that is obtained in the step of producing the alloy powder 50, and beads are put into the pulverization container 210 of the dry bead mill apparatus 200. For example, the amount of the alloy powder 50 that is put-into may be set to be equal to or more than 100 g and equal to or less than 1 kg, and the amount of the beads which are put-into may be set to be equal to or more than 500 g and equal to or less than 1500 g. For example, ZrO₂ beads or SUSj-2 beads can be used as the beads. For example, the diameter of the beads, which can be used, may be set to be equal to or more than 0.5 mm or equal to or less than 10 mm.

In a case of producing the alloy powder 50 by the above-described atomization method, the alloy powder 50 that is collected by the collection chamber 120 and the alloy powder 50 that is collected by the collection chamber 122 may be put into the pulverization container 210 of the dry bead mill apparatus 200, or only the alloy powder 50 that is collected by the collection chamber 120 may be put into the pulverization container 210. In addition, after the step of producing the alloy powder 50, the alloy powder 50 can be used after appropriately sorting a particle size of the alloy powder 50. A particle median diameter of the alloy powder 50 that is put into the pulverization container 210, that is, the alloy powder 50 before performing the pulverization step is preferably equal to or more than 1 µm, and more preferably equal to or more than 10 µm.

Next, the inside of the pulverization container 210 is evacuated by the exhaust unit 220, and an inert gas is introduced into the pulverization container 210, which is evacuated, by the inert gas supply unit 224. Inert gas substitution as described above is repeated five or more times to set an oxygen concentration, which is measured by the oxygen concentration measurement unit 222, on an inner side of the pulverization container 210 to 100 ppm or less. The agitator 240 is driven under the condition in which the oxygen concentration is equal to or less than 100 ppm, and the alloy powder 50 inside the pulverization container 210 is pulverized by rotation of the agitator 240. For example, a rotation speed of the agitator is equal to or faster than 100 rpm and equal to or slower than 2500 rpm.

A minute amount of inert gas is allowed to continuously flow into the inside of the pulverization container 210 during continuous operation of the agitator 240 to maintain the inside of the pulverization container 210 to be equal to or higher than the atmospheric pressure. According to this, the oxygen concentration inside the pulverization container 210 can be maintained to a low concentration. The pulverization container 210 is cooled down by the cooling unit 226 during continuous operation of the agitator 240. According to this, heat that occurs at the inside of the pulverization container 210 due to friction is wasted. At this time, the cooling unit 226 may be controlled to constantly maintain the temperature, which is measured by the temperature measurement unit 228, on an inner side the pulverization container 210. The agitator 240 is stopped at a point of time at which operating time that is set has passed, and the discharging valve 232 is opened to transfer a pulverized material of the alloy powder 50 to the collection container 230. For example, the operating time (pulverization time) is equal to or longer than 30 minutes and equal to or shorter than 10 hours. A filter having a plurality of openings smaller than each of the beads is attached to the discharging valve 232, and thus only a pulverized material of the alloy powder 50 which is smaller than the openings is collected to the collection container 230. The collection container 230 is filled with an inert gas in advance, and thus the pulverized material of the alloy powder 50 is collected without being exposed to the air.

When the alloy powder 50 is pulverized as described above, and the agitator 240 is stopped, the pulverized material of the alloy powder 50 may be aggregated and fixed to the inner wall of the pulverization container 210. In this case, when collection in the collection container 230 is difficult, an aggregate 60 that is aggregated is collected as follows. First, the inside of the pulverization container 210 is filled with an inert gas, and is hermetically closed. Then, the pulverization container 210 is separated from the dry bead mill apparatus 200, and is carried into a glove box that is filled with an inert gas. The pulverization container 210 is opened in the glove box, and the aggregate 60 is peeled off from the wall surface and is collected. Furthermore, the beads are not mixed in the fixed material, and only the pulverized material of the alloy powder is fixed. The aggregate 60 is put into a mixer and is pulverized in an inert gas atmosphere for several tens of seconds to several minutes, and is used at a next step.

In the pulverization step, for example, a ball mill method, a wet bead mill method, a jet mill method, and the like may be used instead of the dry bead mill method, and it is preferable to use the dry bead mill method or the ball mill method among the methods. When using the dry bead mill method or the ball mill method, it is possible to stably manufacture the thermoelectric conversion material that is excellent in a balance between the average particle diameter d and the oxygen content, and is also excellent in the thermoelectric conversion performance.

In a case of performing the pulverization step by using the ball mill method, first, the alloy powder 50 that is obtained in the step of producing the alloy powder 50, and balls are put into a pot of a ball mill apparatus in a glove box in which an oxygen concentration is less than 0.01 wt%. For example, the amount of the alloy powder 50 that is put-into may be set to be equal to or more than 5 g and equal to or less than 200 g. For example, ZrO₂ balls can be used as the balls. A diameter of the balls, which can be used, may be set, for example, to be equal to or larger than 1 mm and equal to or smaller than 50 mm, and the amount of the balls which are put-into the pot may be set to be equal to or more than 30 g and equal to or less than 1 kg. For example, when rotating the pot at a rotation speed that is equal to or faster than 100 rpm and equal to or slower than 1000 rpm, it is possible to pulverize the alloy powder 50. In addition, for example, the rotation may be performed at an acceleration that is faster than 5 G and equal to or slower than 30 G. Pulverization time may be set to be equal to or longer than five minutes and equal to or shorter than 3000 minutes.

The parent-phase particles 22, the nanoparticles 30, and the aggregate 60 of the parent-phase particles 22 and the nanoparticles 30 may be included in the pulverized material, which is obtained by the pulverization step, of the alloy powder 50. Furthermore, the nanoparticles 30 may also exist as an oxidized layer that is formed at least a part of a surface of the parent-phase particles 22. The pulverization step will be described later in detail.

Next, the pulverized material (a mixture including the parent-phase particles 22 and the nanoparticles 30), which is obtained by the pulverization step, of the alloy powder 50 is sintered. For example, the sintering step according to this embodiment can be performed by an SPS method. For example, the SPS method is performed as follows. First, the pulverized material of the alloy powder 50 is put into a carbon dice, and is heated to a temperature of 500°C to 750°C while applying a pulse current thereto under a pressure of 20 to 60 MPa in vacuo or in an inert gas atmosphere. Then, retention is performed for 10 minutes. Next, the pulverized material is cooled down to room temperature.

In this manner, the thermoelectric conversion material 10 according to this embodiment is manufactured.

Here, description has been given an example in which the sintering step is performed by using the SPS method, but there is no limitation to the example. For example, a hot press method, a heating and sintering method, a heat treatment method, and the like can be used instead of the SPS method.

Furthermore, in the sintering step, the particle diameter of the particle group in the thermoelectric conversion material 10 may be enlarged in comparison to the particle diameter of the alloy powder 50 after pulverization due to mutual binding of particles or grain growth of the particles. The above-described average particle diameter d is focused on a particle diameter in the thermoelectric conversion material 10.

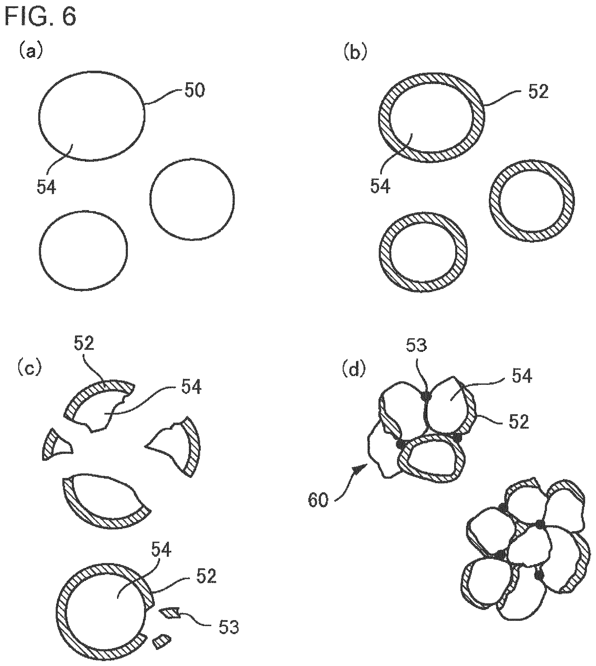

Here, an example of the pulverization step according to this embodiment will be described in detail with reference to FIG. 6. Furthermore, the drawing represents a cross-sectional view of particles before the pulverization step or in the pulverization step, and the size of the particles or the thickness of the oxidized layer are different from an actual ratio.

First, the alloy powder 50 immediately after the step of producing the alloy powder 50 is composed of a nonoxide 54 of an alloy as illustrated in FIG. 6(a). Furthermore, oxygen, which is unintentionally substituted or mixed-in, may slightly exist in the nonoxide 54. However, hereinafter, "nonoxide" is used for convenience. An oxidized layer 52 is hardly formed on a surface of the nonoxide 54. In the pulverization step, first, the alloy powder 50 is stirred in a gas or a liquid. At this time, the outermost surface of the nonoxide 54 is oxidized due to oxygen contained in the gas or the liquid, and the like, and the oxidized layer 52 is formed on the surface of the alloy powder 50 as illustrated in FIG. 6(b). In the example of the pulverization step using the dry bead mill method, the alloy powder 50 is pulverized in an inert gas. However, it is difficult to completely exclude oxygen, and thus the oxidization occurs. Here, the oxidized layer 52 has an oxide composition in which the nonoxide 54 is oxidized. Alternatively, the oxidized layer 52 is composed of an oxide that includes at least one element that constitutes a crystalline structure of the nonoxide 54. For example, in a case where the nonoxide 54 includes Yb, the oxidized layer 52 is composed of Yb₂O₃. For example, in a case where the nonoxide 54 includes La, the oxidized layer 52 is composed of La₂O₃.

The pulverization step is accompanied with pulverization of particles. For example, when the particles of the alloy powder 50 are pulverized, as illustrated in FIG. 6(c), relatively smaller particles including the oxidized layer 52 and the nonoxide 54 may be generated, or a part of the oxidized layer 52 on a particle surface is peeled off, and thus fine particles 53 composed of only an oxide may be generated. The particles may be further pulverized, and relatively smaller particles may be generated. The nonoxide 54 is newly exposed from a surface of particles which occur in the pulverization or particles from which the oxidized layer 52 is partially peeled off. The surface of the nonoxide 54 that is exposed may be newly oxidized during a subsequent pulverization step.

In addition, the pulverization step is accompanied with mutual aggregation of particles. For example, particles, which occur through pulverization of the alloy powder 50 , are mutually aggregated to each other, for example, due to a pressure or heat to form an aggregate 60 as illustrated in FIG. 6(d). Particles which occur due to pulverization, for example, the fine particles 53, or particles including the oxidized layer 52 and the nonoxide 54, and the like may be included in the aggregate 60. In the aggregate 60, oxidation of particles is likely to occur on a surface of the aggregate 60, but oxidation of particles is suppressed at the inside of the aggregate 60. The aggregate 60 may be further pulverized in the pulverization step, and may be separated into a relatively smaller aggregate 60 or particles. In addition, a plurality of the aggregates 60 may be further aggregated to form a relatively larger aggregate 60.

In the pulverization step, as described above, the alloy powder 50 is pulverized while repeating pulverization and mutual aggregating. The pulverized material of the alloy powder 50, which is obtained in the pulverization step, includes the nonoxide 54 as the parent-phase particles 22, and the fine particles 53 and the oxidized layer 52 as the nanoparticles 30. In addition, the pulverized material includes the aggregate 60 of the parent-phase particles 22 or the nanoparticles 30. Furthermore, the oxidized layer 52 is included in a state of being formed on a part or the entirety of a surface of the parent-phase particles 22 as the nanoparticles 30 having a layer shape. Furthermore, compositions of a plurality of the nanoparticles 30 are not limited to be the same as each other, and the respective nanoparticles 30 may have compositions different from each other.

As described above, in the pulverization step, it is preferable that the aggregate 60 obtained through aggregation of the parent-phase particles 22 and the nanoparticles 30 is generated. When the aggregate 60 is generated, it is possible to allow oxidation in the pulverization step to mildly proceed, and it is possible to further improve controllability of the oxygen content of the thermoelectric conversion material 10. In the pulverization step, for example, in a case of performing the pulverization step by using the dry bead mill, particles are heated up to approximately 200°C, and are stirred by the agitator 240 or compressed to the pulverization container 210. According to this the particles are pressurized, and thus the aggregate 60 is generated during the pulverization.

In the pulverization step, it is preferable to perform pulverization by using a dry method in which the alloy powder 50 is pulverized in a gas or in vacuo. In addition, it is more preferable to pulverize the alloy powder 50 by the dry bead mill method. When using the method, the aggregate 60 is more likely to be formed. According to this, it is possible to allow oxidation to mildly proceed, and it is possible to further improve controllability of the oxygen content of the thermoelectric conversion material 10.

In the pulverization step, it is preferable not to use a dispersing agent. When not using the dispersing agent, the aggregate 60 is more likely to be formed. According to this, it is possible to allow oxidation to mildly proceed, and it is possible to further improve controllability of the oxygen content of the thermoelectric conversion material 10.

For example, the average particle diameter d, the oxygen content of the thermoelectric conversion material 10, and the carrier concentration may be adjusted by compositely controlling particle conditions of the alloy powder 50 before the pulverization step, or conditions of the pulverization step. Examples of the particle conditions of the alloy powder 50 before the pulverization step include a production method of the alloy powder 50, a composition and a particle diameter of the alloy powder 50, and the like. In addition, for example, in a case of using the dry bead mill method, examples of the conditions of the pulverization step include a size of beads which are used, the amount of the beads, the amount of the alloy powder 50 that is introduced into the pulverization container 210, a rotation speed and continuous operating time of the agitator 240, a temperature of the pulverization container 210, an oxygen concentration inside the pulverization container 210, and the like.

Next, description will be given of an operational effect of this embodiment.

In the thermoelectric conversion material 10 according to this embodiment, the average particle diameter d of the particle group including the parent-phase particles 22 and the nanoparticles 30 is optimized, and thus satisfactory thermoelectric conversion efficiency is obtained.

As one index indicating performance of the thermoelectric conversion material, a dimensionless figure of merit ZT is exemplified. The ZT is expressed by ZT=S²T/(((κₑₗ+κₚₕ)ρ). Here, κₑₗ represents thermal conductivity by an electron, κₚₕ represents thermal conductivity by a phonon, and a relationship of κ= κₑₗ+ κₚₕ is established.

To raise the ZT, for example, a method of decreasing the diameter of particles included in the thermoelectric conversion material is considered. When decreasing the particle diameter, a particle interface increases, and thus it is possible to lower κₚₕ.

On the other hand, as the particle diameter decreases, a surface area, which is in contact with oxygen, in a powder before the sintering step increases, a content ratio of an oxide in the thermoelectric conversion material increases. An effect due to distribution of the oxide and the like are not clear, but a variation of the content ratio of the oxide causes a variation of a carrier concentration in the thermoelectric conversion material. In addition, S, p, and κₑₗ depend on the carrier concentration, and thus the ZT is affected by the degree of oxidation in addition to the variation of the particle diameter. That is, it is necessary to compositely optimize the particle diameter, the oxygen content, the carrier concentration, and the like so as to improve the conversion performance of the thermoelectric conversion material. In the invention, the particle diameter is set to an appropriate condition. According to this, it is possible to provide a thermoelectric conversion material that is excellent in balance and the conversion performance.

In addition, an additional improvement of the thermoelectric conversion efficiency is realized by accurately controlling the amount of oxidation in combination with the particle diameter. In the method of manufacturing the thermoelectric conversion material according to this embodiment, when performing pulverization of the alloy powder, the particles are pulverized, and the pulverization is accompanied with aggregation. According to this, it is possible to suppress oxidation in aggregated particles, and it is possible to allow oxidation of the entirety of the material to mildly proceed. In addition, it is possible to easily control the oxygen content in the thermoelectric conversion material.

In addition, in the step of pulverizing the alloy powder, as described above, an oxidized layer is formed on a particle surface of the alloy powder, and the oxidized layer that is formed is at least partially peeled off during pulverization. The oxidized layer, which is peeled off, can be dispersed as a nanoparticle. Accordingly, it is possible to allow nanoparticles of an oxide with a small diameter to be appropriately contained in a matrix by adjusting pulverization conditions.

Patent Document 1 discloses a method of decreasing thermal conductivity. In the method, oxide nanoparticles having various sizes are contained in the thermoelectric conversion material to cause phonon scattering. In the method, a particulate-aggregated assembly of a parent-phase component or a nanoparticle component is generated in a solution, the parent-phase component is alloyed through a hydrothermal treatment, and nanoparticles are oxidized. In the thermoelectric conversion material that is obtained through the synthesis as described above, a grain size of the parent-phase component and a diameter of the nanoparticles decrease, and thus the grain size of the parent phase in Patent Document 1 is approximately 30 nm. Since the particle diameter is small, and thus thermal conductivity by a phonon decreases. However, in the hydrothermal treatment, an oxidized layer may be formed on a surface of not only the nanoparticles but also the parent-phase particles. When the particle diameter is small, the oxygen content in the entirety of a material increases. In addition, it is also difficult to control the oxygen content. That is, in the thermoelectric conversion material as described above, excessive oxygen is contained, and thus the thermoelectric conversion performance deteriorates.

### Examples

Hereinafter, the invention will be described in detail with reference to Examples. Furthermore, this embodiment is not limited to description of Examples.

### (Example 1)

### [1] Preparation of Raw Material

First, 146 g of a pure metal of Yb, 11 g of a pure metal of Ca, 8 g of a pure metal of Al, 20 g of a pure metal of Ga, 33 g of a pure metal of In, 40 g of a pure metal of Fe, 621 g of a pure metal of Co, 4100 g of an elementary substance of Sb were respectively prepared as raw materials.

### [2] Production of Alloy Powder

Next, production of an alloy powder was performed. Specifically, first, the respective raw materials, which were prepared in the column [1], were put into a crucible of a gas atomization apparatus, and were melted by heating the raw materials up to 1200°C through high-frequency heating. Next, a temperature of the raw materials which were retained in the crucible was raised up to 1250°C for two minutes through high-frequency heating. Next, the melted raw materials in the crucible were sprayed to a spraying chamber to produce the alloy powder. The alloy powder that was generated was collected by a collection chamber located on a lower side of the spraying chamber, and a collection chamber provided on a lower side of a powder separator provided on a later side of the spraying chamber. Next, a plurality of the alloy powders were classified to obtain an alloy powder having a particle diameter of 150 µm or less.

### [3] Pulverization of Alloy Powder

Next, the alloy powder was pulverized by a dry bead mill method. Specifically, first, 500 g of the alloy powder obtained through the classification in the column [2], and 1200 g of ZrO₂ beads were put into a pulverization container of a dry bead mill apparatus. Bead 1 having a diameter of 2 mm was used as the beads. Next, evacuation of the inside of the pulverization container and introduction of an argon gas were repeated five times to set an oxygen concentration inside the pulverization container to 100 ppm or less. Next, an agitator was driven for five hours at a rotation speed of 415 rpm to obtain a pulverized material (mixture including parent-phase particles and nanoparticle) of the alloy powder. During the pulverization, a minute amount of argon gas was allowed to continuously flow into the inside of the pulverization container, and the pulverization container was cooled down with a water cooling type chiller.

### [4] Sintering of Pulverized Material

Next, the pulverized material was sintered. Specifically, first, the pulverized material obtained in the column [3] was put into a carbon dice. Next, a pulse current was allowed to flow at a pressure of 40 MPa in an argon gas atmosphere to heat the pulverized material up to a temperature of 700°C. After retention for 10 minutes as it was, the pulverized material was cooled down to room temperature. In this manner, a thermoelectric conversion material of n-type skutterudite expressed by Yb_{0.3}Ca_{0.1}Al_{0.1}Ga_{0.1}In_{0.1}Fe_{0.25}Co_{3.75}Sb₁₂ was obtained. A composition of the thermoelectric conversion material was measured by inductively coupled plasma (ICP) analysis.

### (Example 2)

A thermoelectric conversion material of n-type skutterudite expressed by Yb_{0.3}Ca_{0.1}Al_{0.1}Ga_{0.1}In_{0.1}Fe_{0.25}Co_{3.75}Sb₁₂ was obtained in the same manner as in Example 1 except that pulverization was performed by using Bead 2 having a diameter of 3 mm instead of Bead 1 in comparison to the column [3].

### (Example 3)

A thermoelectric conversion material of n-type skutterudite expressed by Yb_{0.3}Ca_{0.1}Al_{0.1}Ga_{0.1}In_{0.1}Fe_{0.25}Co_{3.75}Sb₁₂ was obtained in the same manner as in Example 1 except that the amount of the alloy powder that was put into the pulverization container was set to 300 g and pulverization was performed by using Bead 3 having a diameter of 5 mm instead of Bead 1 in comparison to the column [3].

### (Example 4)

A thermoelectric conversion material of n-type skutterudite expressed by Yb_{0.3}Ca_{0.1}Al_{0.1}Ga_{0.1}In_{0.1}Fe_{0.25}Co_{3.75}Sb₁₂ was obtained in the same manner as in Example 1 except that pulverization was performed by using Bead 3 instead of Bead 1 in comparison to the column [3].

### (Example 5)

A thermoelectric conversion material of n-type skutterudite expressed by Yb_{0.3}Ca_{0.1}Al_{0.1}Ga_{0.1}In_{0.1}Fe_{0.25}Co_{3.75}Sb₁₂ was obtained in the same manner as in Example 1 except that the amount of the alloy powder that was put into the pulverization container was set to 700 g and pulverization was performed by using Bead 3 instead of Bead 1 in comparison to the column [3].

### (Example 6)

A thermoelectric conversion material of n-type skutterudite expressed by Yb_{0.3}Ca_{0.1}Al_{0.1}Ga_{0.1}In_{0.1}Fe_{0.25}Co_{3.75}Sb₁₂ was obtained in the same manner as in Example 1 except that pulverization was performed by using Bead 4 having a diameter of 10 mm instead of Bead 1 in comparison to the column [3].

### (Example 7)

A thermoelectric conversion material of n-type skutterudite expressed by Yb_{0.3}Ca_{0.1}Al_{0.1}Ga_{0.1}In_{0.1}Fe_{0.25}Co_{3.75}Sb₁₂ was obtained in the same manner as in Example 1 except that pulverization was performed by using Bead 4 instead of Bead 1 and pulverization time (operating time of the agitator) was set to 2.5 hours in comparison to the column [3].

### (Example 8)

A thermoelectric conversion material of n-type skutterudite expressed by Yb_{0.3}Ca_{0.1}Al_{0.1}Ga_{0.1}In_{0.1}Fe_{0.25}Co_{3.75}Sb₁₂ was obtained in the same manner as in Example 1 except that the amount of the alloy powder that was put into the pulverization container was set to 700 g and pulverization was performed by using Bead 4 instead of Bead 1 in comparison to the column [3].

### (Example 9)

A thermoelectric conversion material of n-type skutterudite expressed by Yb_{0.3}Ca_{0.1}Al_{0.1}Ga_{0.1}In_{0.1}Fe_{0.25}Co_{3.75}Sb₁₂ was obtained in the same manner as in Example 1 except that the amount of the alloy powder that was put into the pulverization container was set to 900 g and pulverization was performed by using Bead 4 instead of Bead 1 in comparison to the column [3].

Conditions of the dry bead mill in Example 1 to Example 9, and Comparative Example 2 to be described later are collectively shown in Table 1.

**[Table 1]**

| | Example 1 | Example 2 | Example 3 | Example 4 | Example 5 | Example 6 | Example 7 | Example 8 | Example 9 | Comparative Example 2 |
|---|---|---|---|---|---|---|---|---|---|---|
| Material of bead | ZrO₂ | ZrO₂ | ZrO₂ | ZrO₂ | ZrO₂ | ZrO₂ | ZrO₂ | ZrO₂ | ZrO₂ | SUSj-2 |
| Diameter of bead (mm) | 2 | 3 | 5 | 5 | 5 | 10 | 10 | 10 | 10 | 10 |
| Amount of alloy powder that is put-into (g) | 500 | 500 | 300 | 500 | 700 | 500 | 500 | 700 | 900 | 1800 |
| Pulverization time (hour) | 5 | 5 | 5 | 5 | 5 | 5 | 2.5 | 5 | 5 | 16 |

### (Example 10)

A thermoelectric conversion material of n-type skutterudite expressed by Yb_{0.3}Ca_{0.1}Al_{0.1}Ga_{0.1}In_{0.1}Fe_{0.25}Co_{3.75}Sb₁₂ was obtained in the same manner as in Example 1 except that the alloy powder was pulverized by using a ball mill method was used instead of the dry bead mill method in comparison to the column [3]. Specifically, pulverization using the ball mill method was performed as follows. 15 g of the alloy powder obtained through classification in the column [2], and 200 g of ZrO₂ balls having a diameter of 5 mm were put into a pot of a ball mill apparatus in a glove box in which an oxygen concentration was less than 0.01 wt%, and ball milling was performed at a rotation speed of 400 rpm (corresponding to acceleration of 20 G) for pulverization time of 1800 minutes, thereby obtaining a pulverized material of the alloy powder.

### (Example 11 to Example 16)

An alloy powder was pulverized by carrying out the ball mill method under conditions in Table 2 instead of the dry bead mill method in comparison to the column [3]. Furthermore, the alloy powder was pulverized in the same manner as in Example 10 except for conditions in Table 2.

The other steps were performed in the same manner as in Example 1, thereby obtaining a thermoelectric conversion material of n-type skutterudite expressed by Yb_{0.3}Ca_{0.1}Al_{0.1}Ga_{0.1}In_{0.1}Fe_{0.25}Co_{3.75}Sb₁₂.

**[Table 2]**

| | Example 10 | Example 11 | Example 12 | Example 13 | Example 14 | Example 15 | Example 16 |
|---|---|---|---|---|---|---|---|
| Diameter of ball (mm) | 5 | 5 | 5 | 2 | 5 | 5 | 10 |
| Amount of ball that is put-into (g) | 200 | 200 | 200 | 200 | 50 | 200 | 200 |
| Rotation speed (rpm) | 400 | 400 | 400 | 400 | 400 | 280 | 400 |
| Acceleration (G) | 20 | 20 | 20 | 20 | 20 | 10 | 20 |
| Pulverization time (minute) | 1800 | 480 | 10 | 1800 | 1800 | 1800 | 1800 |

### (Example 17)

First, raw materials were prepared in a total weight of 20 g and in the same element weight ratio as in the column [1]. Then, an alloy powder was obtained from the raw materials which were prepared by using a single-roll melt spinning method instead of the gas atomization method in the column [2]. Next, a plurality of the alloy powders were classified to obtain an alloy powder having a particle diameter of 150 µm or less. The alloy powder obtained through the classification was pulverized by the ball mill method. Finally, a pulverized material of the alloy powder was sintered in the same manner as in the column [4], thereby obtaining thermoelectric conversion material of n-type skutterudite expressed by Yb_{0.3}Ca_{0.1}Al_{0.1}Ga_{0.1}In_{0.1}Fe_{0.25}Co_{3.75}Sb₁₂.

Here, the single-roll melt spinning method was performed as follows. First, a raw material, which was prepared, was set in melting crucible of a single-roll spinning apparatus, and was subjected to high-frequency heating up to 1200°C in vacuo of 2×10⁻³ Pa, and retention was performed for one minute. Then, the raw material that was melted was sprayed to a rotating Cu roll through a spraying nozzle having a diameter of 0.5 mm, thereby obtaining a flake-shaped alloy powder. As the Cu roll, a Cu roll having a diameter of 300 mm was used, and the Cu roll was rotated at a rotation speed of 2500 rpm.

In addition, the ball mill method was performed in the same manner as in Example 10.

### (Comparative Example 1)

A thermoelectric conversion material of n-type skutterudite expressed by Yb_{0.3}Ca_{0.1}Al_{0.1}Ga_{0.1}In_{0.1}Fe_{0.25}Co_{3.75}Sb₁₂ was obtained in the same manner as in Example 1 except that the alloy powder obtained through classification in the column [2] was sintered without being pulverized instead of the pulverized material in comparison to the column [4].

### (Comparative Example 2)

A thermoelectric conversion material of n-type skutterudite expressed by Yb_{0.3}Ca_{0.1}Al_{0.1}Ga_{0.1}In_{0.1}Fe_{0.25}Co_{3.75}Sb₁₂ was obtained in the same manner as in Example 1 except that the amount of the alloy powder that was put into the pulverization container was set to 1800 g, pulverization was performed by using SUSj-2 Bead 5 having a diameter of 10 mm instead of Bead 1, and the pulverization time (operating time of the agitator) was set to 16 hours in comparison to column [3].

### (Comparative Example 3)

A thermoelectric conversion material of n-type skutterudite expressed by Yb_{0.3}Ca_{0.1}Al_{0.1}Ga_{0.1}In_{0.1}Fe_{0.25}Co_{3.75}Sb₁₂ was obtained through pulverization with a wet bead mill method instead of the dry bead mill method in comparison to the column [3]. Steps other than the pulverization step were performed in the same manner as in Example 1, thereby obtaining the thermoelectric conversion material.

Specifically, the pulverization method using the wet bead mill method was performed as follows. First, 200 g of the alloy powder obtained through classification in the column [2], 485 g of ZrO₂ beads, and 800 g of isopropyl alcohol were put into a pulverization container of a wet bead mill apparatus. As the beads, beads having a diameter of 1 mm were used. Bead milling was performed for 30 minutes under conditions in which a filling rate was set to 85% of a volume of the pulverization container, a flow rate of the wet bead mill was set to 0.35 L/min, a peripheral speed was set to 12 m/s, and a screen aperture was set to 0.3 mm. Next, bead milling was performed for 30 minutes in a state in which the diameter of the ZrO₂ beads was changed to 0.2 mm, and the screen aperture was changed to 0.07 mm. In addition, bead milling was performed for 30 minutes in a state in which the diameter of the ZrO₂ beads was changed to 0.1 mm, and the screen aperture was changed to 0.03 mm. During pulverization, the pulverization container was cooled down with a water cooling type chiller. The ZrO₂ beads and the isopropyl alcohol were separated from slurry that was obtained as described above, the slurry was dried to obtain a pulverized material of the alloy powder.

### <Evaluation of Thermoelectric Conversion Material>

With respect to the thermoelectric conversion materials which were respectively obtained in Example 1 to Example 17, and Comparative Example 1 to Comparative Example 3, the oxygen content, the average particle diameter, presence or absence of the nanoparticles, and the ZT integrated value were measured as follows.

### (Oxygen Content)

The oxygen content of the thermoelectric conversion material was measured. The oxygen content was measured by an inert gas dissolution method by using an oxygen/nitrogen/hydrogen analysis device (TC-436AR manufactured by LECO JAPAN CORPORATION).

The oxygen content was 0.41 mass% in Example 1, 0.33 mass% in Example 2, 0.43 mass% in Example 3, 0.31 mass% in Example 4, 0.26 mass% in Example 5, 0.31 mass% in Example 6, 0.22 mass% in Example 7, 0.20 mass% in Example 8, 0.17 mass% in Example 9, 0.19 mass% in Example 10, 0.22 mass% in Example 11, 0.38 mass% in Example 12, 0.20 mass% in Example 13, 0.23 mass% in Example 14, 0.20 mass% in Example 15, 0.23 mass% in Example 16, 0.21 mass% in Example 17, 0.10 mass% in Comparative Example 1, 0.90 mass% in Comparative Example 2, and 2.30 mass% in Comparative Example 3.

### (Average Particle Diameter d)

The average particle diameter d in the thermoelectric conversion material was measured. Specifically, first, a small piece was cut out from the thermoelectric conversion material, and was processed and polished into a sample having a flat surface (exposed surface of a cross-section). The flat surface of the sample was observed by using a scanning electron microscope (S4700 manufactured by Hitachi High-Technologies Corporation). First, one sheet of observation image was acquired from a range of 6 µm×4 µm, and the average particle diameter d was obtained through image analysis. In Comparative Example 1 and Comparative Example 2, a particle diameter exceeded a size of the above-described range, and thus an observation image of a relatively wide range was acquired to obtain the average particle diameter. In the image analysis, first, an interface between particles in the observation image was extracted. In a case where the interface that was extracted was closed in the observation image, an inner side of the closed interface was regarded as a cross-section of one particle, and the inner side was extracted. A cross-sectional area and an equivalent circle diameter of cross-sections of a plurality of particles which were extracted from the observation image were respectively obtained. Here, an area of a circle in which the equivalent circle diameter was set as a diameter, and the cross-sectional area are the same as each other. An average value of 20 or more equivalent circle diameters was set to the average particle diameter d.

The average particle diameter d was 530 nm in Example 1, 450 nm in Example 2, 510 nm in Example 3, 550 nm in Example 4, 680 nm in Example 5, 530 nm in Example 6, 237 nm in Example 7, 317 nm in Example 8, 266 nm in Example 9, 298 nm in Example 10, 320 nm in Example 11, 786 nm in Example 12, 520 nm in Example 13, 318 nm in Example 14, 550 nm in Example 15, 424 nm in Example 16, 560 nm in Example 17, 150000 nm in Comparative Example 1, 6000 nm in Comparative Example 2, and 50 nm in Comparative Example 3.

### (Presence or Absence of Nanoparticles)

A broken surface was analyzed by using an EDX apparatus. In the thermoelectric conversion materials of Example 1 to Example 17, and Comparative Example 1 to Comparative Example 3, a layer (layered nanoparticles) in which the oxygen content ratio was higher in comparison to the parent-phase particles was confirmed at an interface of parent-phase particles. The nanoparticles were oxides including at least one of elements including Yb, Ca, Al, Ga, In, Fe, Co, and Sb which constitute the parent-phase particles. In addition, in the thermoelectric conversion materials of Example 1 to Example 17, Comparative Example 2, and Comparative Example 3, a plurality of spherical particles (spherical nanoparticles) having a particle diameter of 50 nm or less, in which the oxygen content ratio was higher in comparison to the parent-phase particles, were observed. On the other hand, in the thermoelectric conversion material of Comparative Example 1, the spherical nanoparticles significantly decreased.

### (ZT Integrated Value)

The ZT integrated value of the thermoelectric conversion material was measured. Specifically, first, a Seebeck coefficient S, electrical resistivity p, and thermal conductivity κ were measured in a temperature range of 100°C to 600°C by using a thermoelectric characteristic evaluation device (ZEM-2 manufactured by ADVANCE RIKO Inc.) and a laser flash method thermal constant measurement device (TC-7000H manufactured by ADVANCE RIKO, Inc.). In addition, the dimensionless figure of merit ZT was calculated from a relationship of ZT=S²T/(κ·ρ), and the ZT was integrated in a temperature range of 100°C to 600°C to obtain a ZT integrated value.

The ZT integrated value was 372 K in Example 1, 396 K in Example 2, 376 K in Example 3, 422 K in Example 4, 449 K in Example 5, 423 K in Example 6, 419 K in Example 7, 415 K in Example 8, 387 K in Example 9, 395 K in Example 10, 400 K in Example 11, 371 K in Example 12, 399 K in Example 13, 388 K in Example 14, 430 K in Example 15, 411 K in Example 16, 400 K in Example 17, 360 K in Comparative Example 1, 8 K in Comparative Example 2, and 5 K in Comparative Example 3.

Measurement results of the oxygen content, the average particle diameter, presence or absence of the nanoparticles, and the ZT integrated value are collectively shown in Table 3.

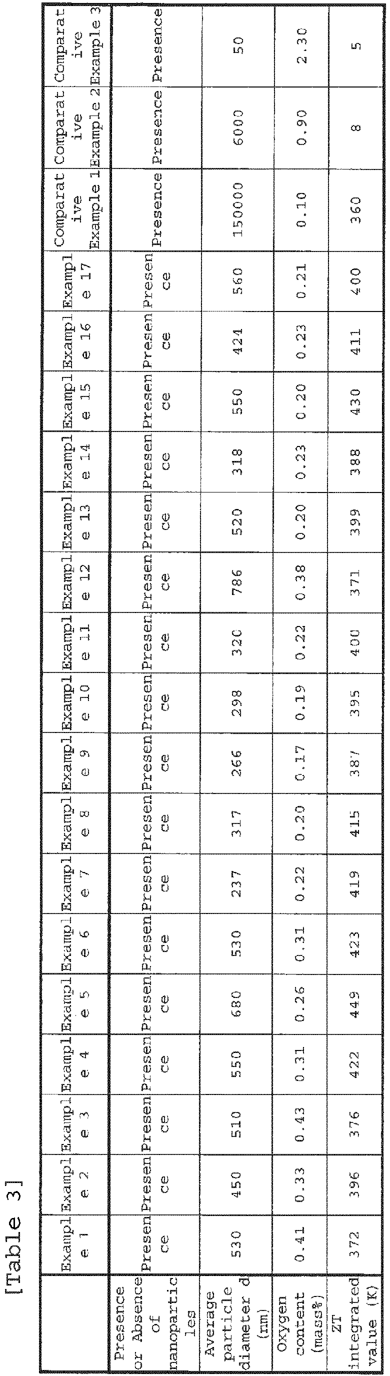

From Table 3, in the thermoelectric conversion materials of Example 1 to Example 17 in which the average particle diameter d was equal to or more than 100 nm and equal to or less than 1000 nm, it was confirmed that the ZT integrated value was high and the thermoelectric conversion performance was excellent. The oxygen content was equal to or less than 10 mass% in Example 1 to Example 17. On the other hand, in Comparative Example 1 to Comparative Example 3 in which the average particle diameter d was out of the above-described range, the ZT integrated value was low.

In addition, from Table 3, in the thermoelectric conversion materials of Example 1 to Example 17 in which the oxygen content was equal to or more than 0.15 mass% and equal to or less than 0.8 mass%, it was confirmed that the ZT integrated value was high and the thermoelectric conversion performance was excellent. On the other hand, in Comparative Example 1 in which the oxygen content was less than 0.15 mass%, and in Comparative Example 2 and Comparative Example 3 in which the oxygen content was more than 0.8 mass%, the ZT integrated value was low.

In addition, the oxygen content in Comparative Example 3 in which the wet bead mill method was used was greatly higher than the oxygen content in Example 1 to Example 9 in which the dry bead mill method was used. Furthermore, even in a case where the average particle diameter d was approximately the same, it was separately confirmed that the oxygen content in the wet bead mill method was higher the oxygen content in the dry bead mill method. The reason for this is considered because particles were pulverized in a state of being dispersed in a liquid in a relatively satisfactory manner, and thus oxidation of the particles excessively proceeded. For example, it can be understood that the excessive oxidation due to satisfactory dispersion of the particles may occur in the same manner even in a case of performing synthesis or a treatment of particles in a solution.

On the other hand, in a case of using the dry method, it is considered that appropriate aggregation occurs, and thus it is possible to further suppress oxidation in comparison to the wet method.

### (Carrier Concentration)

In addition, a carrier concentration of the majority carrier was measured with respect to the thermoelectric conversion material obtained in Example 1 to Example 11, and Comparative Example 1. Measurement was performed by using a hall effect measurement apparatus (Resistest manufactured by TOYO Corporation).

The carrier concentration was 10×10²⁶ m⁻³ in Example 1, 4.4×10²⁶ m⁻³ in Example 2, 3.7×10²⁶ m⁻³ in Example 3, 5.9×10²⁶ m⁻³ in Example 4, 7.1×10²⁶ m⁻³ in Example 5, 5.9×10²⁶ m⁻³ in Example 6, 5.9×10²⁶ m⁻³ in Example 7, 7.1×10²⁶ m⁻³ in Example 8, 8.2×10²⁶ m⁻³ in Example 9, 8.1×10²⁶ m⁻³ in Example 10, 8.5×10²⁶ m⁻³ in Example 11, and 10×10²⁶ m⁻³ in Comparative Example 1.

The measurement results are collectively shown in Table 4 in combination with the ZT integrated value. Furthermore, a unit of the carrier concentration in Table 4, is "×10²⁶ m⁻³".

**[Table 4]**

| | Exampl e 1 | Exampl e 2 | Exampl e 3 | Exampl e 4 | Example e 5 | Exampl e 6 | Exampl e 7 | Exampl e 8 | Exampl e 9 | Exampl e 10 | Exampl e 11 | Comparativ e Example 1 |
|---|---|---|---|---|---|---|---|---|---|---|---|---|
| Carrier concentratio n (^{x}10²⁶ m⁻³) | 10 | 4.4 | 3.7 | 5.9 | 7.1 | 5.9 | 5.9 | 7.1 | 8.2 | 8.1 | 8.5 | 10 |
| ZT integrated value (K) | 372 | 396 | 376 | 422 | 449 | 423 | 419 | 415 | 387 | 395 | 400 | 360 |

From Table 4, it can be seen that in Example 1 to Example 11, the carrier concentration was in a range of equal to or more than 1.0×10²³ m-³ and equal to or less than 1.0×10²⁹ m-³. In addition, in the thermoelectric conversion materials in Example 2, and Example 4 to Example 11 in which the carrier concentration is equal to or more than 4.0×10²⁶ m⁻³ and equal to or less than 9.0×10²⁶ m⁻³, it was confirmed that the ZT integrated value was high and the thermoelectric conversion performance was particularly excellent.

Hereinbefore, description has been given of the embodiment of the invention with reference to the accompanying drawings. However, the embodiment is an example of the invention, and various configuration other than the above-described configuration can be used.

Priority is claimed on Japanese Patent Application No. 2014-183883, filed September 10, 2014, the content of which is incorporated herein by reference.

## Claims

1. A thermoelectric conversion material, comprising:
a plurality of parent-phase particles having a crystalline structure; and
nanoparticles, each including an oxide and existing at an interface between the parent-phase particles,
wherein the nanoparticles include at least one element that constitutes the crystalline structure, and
when a range of 6 µm×4 µm of the thermoelectric conversion material is observed with a scanning electron microscope to acquire one sheet of cross-sectional observation image, an average particle diameter d, which is an average of an equivalent circle diameter of a particle group including the parent-phase particles and the nanoparticles which are observed on the cross-sectional observation image, is equal to or more than 100 nm and equal to or less than 1000 nm.

2. The thermoelectric conversion material according to claim 1,
wherein an oxygen content based on the entirety of the thermoelectric conversion material is equal to or less than 10 mass%.

3. The thermoelectric conversion material according to claim 1 or 2,
wherein the crystalline structure has a composition that is mainly expressed by a general formula RᵣTₜXₓ (0≤r≤1, 3≤t≤5, 9≤x≤15),
R includes one or more kinds of elements selected from the group consisting of rare-earth elements, alkali metal elements, alkaline-earth metal elements, group 4 elements, and group 13 elements,
T includes one or more kinds of elements selected from the group consisting of transition metal elements excluding rare-earth elements and group 4 elements, and
X includes one or more kinds of elements selected from the group consisting of group 14 elements, group 15 elements excluding nitrogen, and group 16 elements excluding oxygen.

4. The thermoelectric conversion material according to any one of claims 1 to 3,
wherein a carrier concentration of the majority carrier is equal to or more than 1.0×10²³ m⁻³ and equal to or less than 1.0×10²⁹ m⁻³.

5. The thermoelectric conversion material according to any one of claims 1 to 4,
wherein a ZT integrated value obtained by integrating a dimensionless figure of merit ZT in a temperature range of 100°C to 600°C is equal to or higher than 170 K.

6. A thermoelectric conversion module, comprising:
the thermoelectric conversion material according to any one of claims 1 to 5.

7. A method of manufacturing a thermoelectric conversion material, the method comprising:
a step of preparing a plurality of raw materials;
a step of producing an alloy powder from the plurality of raw materials;
a pulverization step in which the alloy powder is pulverized to form a plurality of parent-phase particles having a crystalline structure, and nanoparticles including an oxide; and
a step of sintering a mixture including the parent-phase particles and the nanoparticles,
wherein in the pulverization step, the alloy powder is pulverized while repeating pulverization and mutual aggregation, and
when a range of 6 µm×4 µm of the thermoelectric conversion material is observed with a scanning electron microscope to acquire one sheet of cross-sectional observation image, an average particle diameter d, which is an average of an equivalent circle diameter of a particle group including the parent-phase particles and the nanoparticles which are observed on the cross-sectional observation image, is equal to or more than 100 nm and equal to or less than 1000 nm.

8. The method of manufacturing a thermoelectric conversion material according to claim 7,
wherein in the pulverization step, an aggregate, in which the parent-phase particles and the nanoparticles are aggregated, is formed.

9. The method of manufacturing a thermoelectric conversion material according to claim 7 or 8,
wherein in the pulverization step, the alloy powder is pulverized by using a dry method in which the alloy powder is pulverized in a gas or in vacuo.

10. The method of manufacturing a thermoelectric conversion material according to claim 9,
wherein in the pulverization step, the alloy powder is pulverized by a dry bead mill method or a ball mill method.

11. The method of manufacturing a thermoelectric conversion material according to any one of claims 7 to 10,
wherein in the step of producing the alloy powder, the alloy powder is produced by using an atomization method.

12. The method of manufacturing a thermoelectric conversion material according to any one of claims 7 to 10,
wherein in the step of producing the alloy powder, the alloy powder is produced by using a melt spinning method.

13. A thermoelectric conversion material, comprising:
a plurality of parent-phase particles having a crystalline structure; and
nanoparticles each of which includes an oxide and is located at an interface between the parent-phase particles,
wherein the nanoparticles include at least one element that constitutes the crystalline structure, and
an oxygen content based on the entirety of the thermoelectric conversion material is equal to or less than 10 mass%.
